# FASCICULE DE BREVET EUROPEEN

(11) **EP 1 800 188 B1**
(45) Date de publication et mention de la délivrance du brevet: **07.05.2008**
(21) Numéro de dépôt: 05777195.8
(22) Date de dépôt: 14.06.2005
(51) Int. Cl.: G03F 7/20, H05G 2/00, G21K 1/06

(54) **DISPOSITIF DE GENERATION DE LUMIERE DANS L' EXTREME ULTRAVIOLET ET APPLICATION A UNE SOURCE DE LITHOGRAPHIE PAR RAYONNEMENT DANS L'EXTREME ULTRAVIOLET**
VORRICHTUNG ZUR ERZEUGUNG VON EXTREMEM UV-LICHT UND ANWENDUNG AUF EINE LITHOGRAFIEQUELLE MIT EXTREMER UV-STRAHLUNG
DEVICE FOR GENERATING EXTREME ULTRAVIOLET LIGHT AND APPLICATION TO AN EXTREME ULTRAVIOLET RADIATION LITHOGRAPHY SOURCE

(30) Priorité: 14.06.2004 FR 0406429
(43) Date de publication de la demande: 27.06.2007
(73) Titulaire: COMMISSARIAT A L'ENERGIE ATOMIQUE, 75015 Paris (FR); Alcatel Vacuum Technology France, 75008 Paris (FR)
(72) Inventeur: CHEYMOL, Guy, F-91440 BURES SUR YVETTE (FR); CORMONT, Philippe, F-33110 Le Bouscat (FR); THRO, Pierre-Yves, F-91190 GIF SUR YVETTE (FR); SUBLEMONTIER, Olivier, F-92260 FONTENAY AUX ROSES (FR); SCHMIDT, Martin, F-22200 Pommerit le Vicomte (FR); BARTHOD, Benoît, F-74370 NAVES PARMELAN (FR)
(74) Mandataire: Thévenet, Jean-Bruno
(86) Numéro de dépôt international: PCT/FR2005/001465
(87) Numéro de publication internationale: WO 2006/000718

(56) Documents cités:
- EP-A- 1 255 163
- WO-A-02/085080
- US-A- 4 063 088
- US-A1- 2004 109 151

## Description

### Domaine technique

La présente invention concerne un dispositif de génération de lumière dans l'extrême ultraviolet et une application à une source de lithographie par rayonnement dans l'extrême ultraviolet, notamment pour la fabrication de circuits intégrés.

Dans la suite de la description, le rayonnement dans le domaine de l'extrême ultraviolet (couvrant typiquement des longueurs d'onde comprises entre 1 nm et 15 nm) sera également appelé plus simplement "rayonnement EUV".

### Etat de la technique antérieure

Depuis plusieurs décennies, la lithographie optique domine la fabrication des circuits intégrés. C'est au prix d'une évolution permanente que cette technique a su s'adapter aux besoins du marché en produisant des circuits intégrés ayant une résolution de plus en plus fine. L'amélioration de la résolution est obtenue principalement par l'utilisation d'une longueur d'onde de plus en plus courte.

Ainsi, au début de l'ère de la microélectronique dans les années soixante, on a d'abord utilisé des lampes à mercure avec une longueur d'onde de 436 nm puis de 365 nm. Les lasers à excimère ont pris le relais dans les années 1990. Après la génération des lasers KrF à 248 nm, on utilise actuellement des lasers à excimère ArF émettant à une longueur d'onde de 193 nm, ce qui permet d'atteindre des largeurs de traits, également appelées dimensions critiques, d'environ 130 nm.

Si, dans le passé, les dimensions critiques étaient supérieures à la longueur d'onde, depuis le milieu des années 90, avec l'introduction de plusieurs astuces techniques, la lithographie optique permet maintenant de produire des motifs gravés de dimensions nettement inférieures à la longueur d'onde utilisée. En particulier, on peut citer l'emploi de techniques d'interférométrie, de masques de plus en plus sophistiqués et d'optiques de projection de plus en plus précises. Il est maintenant envisagé la réalisation de circuits intégrés avec des dimensions critiques inférieures à 50 nm à comparer aux 110 nm qui représentent aujourd'hui la norme.

Pour obtenir une finesse de gravure inférieure à 50 nm, on a proposé l'introduction de la lithographie dans l'EUV en utilisant des sources émettant un rayonnement de longueur d'onde 13,5 nm, à forte cadence de répétition d'au moins 7 kHz. De façon générale, l'émission EUV est obtenue par la création d'un plasma qui est chauffé à une température électronique optimale, de l'ordre de 20 à 40 eV. Il s'agit donc d'une source dite thermique. Une des possibilités étudiées pour créer ce plasma est d'utiliser un ou plusieurs faisceaux laser focalisés sur une cible sous vide. Ce concept est appelé source plasma produit par laser ("laser produced plasma source" ou source LPP).

Pour avoir une source EUV rentable industriellement, il est toutefois nécessaire d'avoir une puissance EUV moyenne utile, c'est-à-dire une puissance qui est réellement utilisable pour la lithographie, compte tenu des pertes au niveau collecte et transport du rayonnement EUV, très importante, de l'ordre de la centaine de watts. De nombreuses recherches sont menées pour augmenter la puissance EUV utile pour les sources LPP des prochaines générations de répéteurs en photolithographie. Ces recherches portent notamment sur l'amélioration du couplage des lasers avec la cible, l'augmentation du rendement de la source défini par le rapport entre la puissance EUV générée et la puissance électrique consommée, et enfin sur l'optimisation de l'efficacité de la collecte du rayonnement EUV. Il est d'ores et déjà établi qu'il faut injecter une puissance laser moyenne très importante bien supérieure à 10 kW afin d'obtenir une puissance EUV suffisante. Cette augmentation de puissance laser doit se faire en maintenant les efficacités de couplage du laser avec la cible (la qualité spatiale des lasers ne doit pas se détériorer avec l'augmentation de puissance laser), et en maintenant aussi le maximum d'efficacité de collecte du rayonnement EUV émis par le plasma.

L'augmentation de la puissance des sources EUV est un point crucial pour la viabilité de ces sources en photolithographie.

Le document de brevet EP 1 319 988 A2 propose de combiner plusieurs sources EUV pour avoir une source de plus forte puissance mais ce type de solution augmente fortement les coûts.

Pour les sources EUV dont le plasma est créé par excitation laser (sources LPP), il est possible d'augmenter la puissance de la source EUV en augmentant la puissance laser (il s'agit par exemple de laser infrarouge). Habituellement, la puissance du laser injectée sur la cible peut être augmentée en utilisant un oscillateur et un ou plusieurs amplificateurs. Il en résulte alors un laser complexe, coûteux et avec généralement un faible rendement électrique-optique.

En ce qui concerne la collecte du rayonnement EUV plus ou moins isotrope émis par le plasma, le document de brevet EP 1 255 163 A2 propose un dispositif avec deux faisceaux lasers qui passent par deux ouvertures distinctes au travers du premier élément collecteur, qui est un miroir à incidence normale d'une grande ouverture numérique qui se trouve proche du plasma émetteur. Mais ce type de dispositif n'a qu'une réflectivité maximale de 70% ce qui conduit à une forte absorption de radiation et donc à un stress thermique important. De plus, ce dispositif présente une durée de vie limitée car l'empilement de fines multicouches n'est pas résistant aux nombreux débris émis par le plasma.

La demande internationale WO01/99143 décrit par ailleurs, pour le cas d'une source EUV dont le plasma est créé par décharge ("discharge-produced plasma source" ou source DPP), une possible réalisation d'un collecteur de rayonnement EUV à incidence rasante avec filtre anti-débris. Ce type de dispositif n'est pas habituellement utilisé avec les sources LPP.

### Exposé de l'invention

La présente invention a pour but de remédier aux inconvénients de l'art antérieur et de permettre la réalisation d'une source de rayonnement EUV de type LPP de forte puissance moyenne.

L'invention vise plus particulièrement à permettre l'utilisation simultanée de plusieurs faisceaux laser pour augmenter fortement la puissance laser incidente tout en conservant un dispositif efficace de collecte du rayonnement EUV et en limitant les coûts de fabrication et d'utilisation.

Ces buts sont atteints grâce à un dispositif de génération de lumière dans l'extrême ultraviolet, comprenant :
a) une pluralité de sources laser de puissance pour émettre une pluralité de faisceaux laser,
b) des moyens de focalisation des faisceaux laser pour produire des faisceaux laser focalisés,
c) des moyens de création d'un espace sous vide avec une pression inférieure à 1 Pa au moins dans la zone où sont focalisés lesdits faisceaux laser focalisés,
d) un dispositif de création, dans ledit espace où sont focalisés lesdits faisceaux laser focalisés, d'une cible dense apte à émettre par interaction avec lesdits faisceaux laser focalisés un plasma possédant au moins une raie d'émission dans l'extrême ultraviolet,
e) un dispositif récepteur pour recevoir la cible après son interaction avec lesdits faisceaux laser focalisés, et
f) au moins un premier dispositif collecteur du rayonnement EUV émis par la cible,
caractérisé en ce qu'il comprend un axe moyen de collecte de rayonnement EUV perpendiculaire à l'axe défini par la cible dense essentiellement linéaire, en ce que les moyens de focalisation des faisceaux laser sur la cible sont agencés de telle sorte que les faisceaux laser soient focalisés latéralement sur la cible en étant situés dans un même demi-espace par rapport à la cible et en étant inclinés d'un angle prédéterminé compris entre environ 60° et 90° par rapport audit axe moyen de collecte et en ce que ledit premier dispositif collecteur est disposé symétriquement par rapport audit axe moyen de collecte dans le demi-espace contenant les faisceaux laser focalisés sur la cible et à l'intérieur d'un espace conique centré sur l'axe moyen de collecte avec un sommet situé sur la cible et un demi-angle au sommet inférieur à l'angle d'inclinaison des faisceaux laser focalisés par rapport à l'axe moyen de collecte.

Le dispositif de création d'une cible dense essentiellement linéaire, peut comprendre un dispositif d'injection pour créer sous vide un jet filamentaire, un jet liquide ou un brouillard de gouttelettes.

La cible peut également être avantageusement constituée d'un jet formé d'une succession rapide de gouttelettes individuelles synchronisées avec les impulsions laser. Cette dernière solution permet de conserver les avantages du jet filamentaire tout en limitant la quantité de matière introduite dans l'enceinte à vide.

Avantageusement, les faisceaux laser focalisés inclinés par rapport à l'axe moyen de collecte sont disposés en couronne autour de cet axe moyen de collecte.

Si le nombre de sources laser utilisées est important, les faisceaux laser focalisés inclinés peuvent aussi être répartis sur plusieurs couronnes autour de l'axe moyen de collecte.

Le nombre de faisceaux laser focalisés, qui est égal ou supérieur à 2, est de préférence compris entre 3 et 20.

Les faisceaux laser focalisés peuvent être disposés de façon symétrique (par exemple deux groupes de cinq faisceaux laser focalisés) ou de façon non symétrique (par exemple un groupe de quatre faisceaux laser focalisés d'un côté et un groupe de deux faisceaux laser focalisés de l'autre côté) par rapport à un plan contenant l'axe moyen de collecte.

Les moyens de focalisation sont conçus de manière à produire des faisceaux laser focalisés sur de petits diamètres compris entre environ 20 et 300 µm.

Toutefois, pour une application de l'invention dans la microscopie/tomographie EUV dans la fenêtre de transmission de l'eau, c'est-à-dire entre 2,3 et 4,4 nm, la focalisation peut être effectuée de manière à atteindre des diamètres plus petits jusqu'à environ 10 µm. Ceci permet d'accroître la résolution spatiale du microscope.

Selon un mode de réalisation particulier, les moyens de focalisation comprennent des moyens optiques de focalisation pour assurer la focalisation de plusieurs faisceaux laser de puissance dont le produit diamètre-divergence est plusieurs fois supérieur à celui d'un faisceau laser gaussien.

Avantageusement les moyens de focalisation comprennent au moins un miroir qui peut être avantageusement réalisé en matériau métallique ou semiconducteur, tel que du silicium.

Dans ce cas, des moyens de refroidissement peuvent être disposés sur la face arrière du ou des miroirs constituant les moyens de focalisation.

Selon une caractéristique avantageuse, le ou les miroirs constituant les moyens de focalisation présentent une forme ellipsoïdale ou parabolique permettant le passage des faisceaux laser avant focalisation entre le dispositif de création d'une cible et le premier dispositif collecteur.

De préférence, les moyens de focalisation sont disposés en un ou plusieurs anneaux autour du premier dispositif collecteur.

Selon un premier mode de réalisation possible, le premier dispositif collecteur comprend un dispositif à empilement multicouches diélectriques Mo/Si à incidence normale.

Selon un autre mode de réalisation possible, le premier dispositif collecteur comprend un dispositif optique à incidence rasante présentant une surface d'or, ruthénium ou palladium.

Dans ce cas, le premier dispositif collecteur peut comprendre des premier et deuxième éléments de collecteur imbriqués.

Selon une première variante, les premier et deuxième éléments de collecteur imbriqués présentent chacun une forme d'ellipsoïde de révolution autour de l'axe moyen de collecte.

Selon une autre variante, le premier élément de collecteur imbriqué est un élément interne présentant la forme d'un ellipsoïde de révolution autour de l'axe moyen de collecte tandis que le deuxième élément de collecteur imbriqué est un élément externe présentant successivement à partir du côté faisant face à la cible la forme d'un hyperboloïde de révolution et la forme d'un ellipsoïde de révolution (objectif de Wolter).

Le dispositif selon l'invention peut comprendre en outre un deuxième dispositif collecteur disposé symétriquement par rapport à l'axe moyen de collecte dans le demi-espace délimité par la cible et ne contenant pas les faisceaux lasers focalisés sur la cible.

Dans ce cas, avantageusement, le deuxième dispositif collecteur comprend un miroir à incidence normale avec empilement de multicouches dont la surface est sphérique.

### Brève description des dessins

D'autres caractéristiques et avantages de l'invention ressortiront de la description suivante de modes particuliers de réalisation donnés à titre d'exemples, en référence aux dessins annexés, sur lesquels :
- la Figure 1 est une vue schématique, en coupe selon un plan contenant l'axe moyen de collecte, d'un exemple de dispositif de focalisation multi-faisceaux de laser de puissance sur une cible, utilisable dans le cadre du dispositif de génération de lumière EUV selon l'invention,
- la Figure 2 est une vue schématique, en coupe selon le plan II-II de la Figure 1 perpendiculaire à l'axe moyen de collecte, montrant un dispositif de focalisation de dix faisceaux lasers de puissance répartis en couronne de façon symétrique,
- la Figure 3 est une vue schématique en coupe analogue à la Figure 1 avec la représentation du cône d'émission de lumière EUV utile issue de la cible avec laquelle interagissent les faisceaux lasers focalisés,
- la Figure 4 est une vue schématique en coupe analogue à la Figure 3, montrant la mise en oeuvre d'un premier exemple de dispositif collecteur de rayonnement EUV avec incidence normale,
- la Figure 5 est une vue schématique en coupe analogue à la Figure 3, montrant la mise en oeuvre d'un deuxième exemple de dispositif collecteur de rayonnement EUV avec incidence rasante et deux éléments de collecteur imbriqués,
- la Figure 6 est un ensemble de deux courbes donnant la réflectivité en fonction de l'angle d'incidence par rapport à la surface du collecteur EUV, et ce respectivement pour un seul élément de collecteur en forme d'ellipse et avec l'ajout d'un deuxième élément de collecteur en forme d'hyperbole + ellipse (correspondant à un objectif de Wolter),
- la Figure 7 est une vue schématique, en coupe selon un plan contenant l'axe moyen de collecte du dispositif, d'un exemple de dispositif de génération de lumière EUV selon l'invention comprenant deux collecteurs différents de rayonnement EUV situés de part et d'autre de la cible avec laquelle interagissent les faisceaux lasers focalisés, et
- la Figure 8 est une vue schématique, en coupe selon un plan contenant l'axe moyen de collecte du dispositif, d'un mode particulier de réalisation d'un dispositif de génération de lumière EUV selon l'invention utilisant des moyens de focalisation à miroir.

### Exposé détaillé de modes de réalisation particuliers

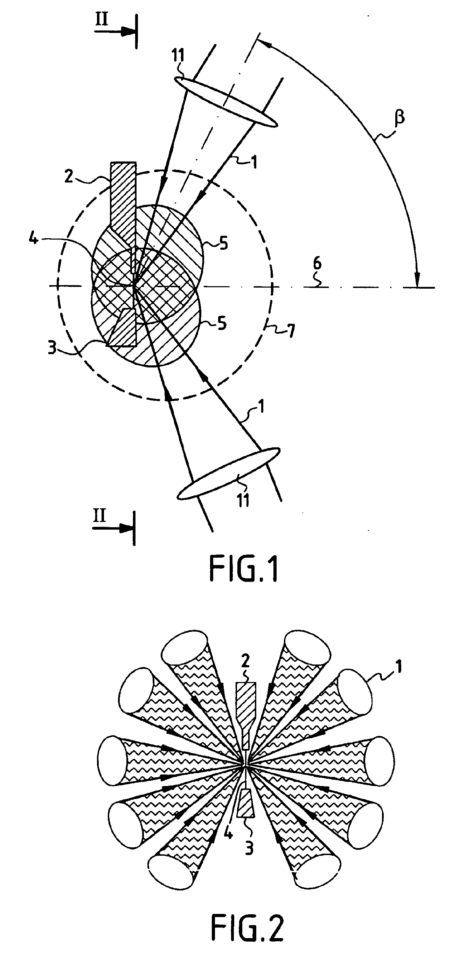

On voit sur la Figure 1 un dispositif injecteur 2 adapté pour créer un jet filamentaire ou un micro-jet liquide ou un jet de gouttelettes individuelles (par exemple d'un gaz rare liquéfié, tel que du xénon ou encore des gouttelettes métalliques par exemple de lithium ou d'étain) constituant une cible 4. Le jet créé sous vide par le dispositif injecteur 2 est récupéré par un dispositif récepteur 3.

La Figure 1 montre deux faisceaux lasers de puissance 1 focalisés par des moyens de focalisation 11, tels que des lentilles, des dispositifs optiques diffractifs (par exemple des réseaux) ou encore des miroirs, sur la cible 4.

Selon l'invention on utilise un nombre de faisceaux lasers de puissance focalisés 1 supérieur ou égal à 2. Les deux faisceaux lasers focalisés 1 représentés sur la Figure 1 sont inclinés chacun d'un angle β compris entre environ 60 et 90° par rapport à l'axe moyen de collecte 6 du dispositif. D'une manière générale, l'attaque latérale des faisceaux lasers focalisés 1 sur la cible 4 permet une meilleure collecte du rayonnement EUV produit.

On a représenté sur la Figure 1 la zone 5 d'émission EUV produite par chaque faisceau laser individuel 1. Généralement, cette émission EUV 5 est centrée en direction du faisceau laser incident correspondant 1, mais cette émission EUV peut être assez isotrope, notamment si l'on utilise une cible 4 de type jet filamentaire ou jet de gouttelettes

Lorsque deux faisceaux lasers 1 sont focalisés latéralement sur la cible 4, en formant un angle β par rapport à l'axe moyen de collecte 6 perpendiculaire à la cible 4, comme représenté sur la Figure 1, la focalisation des deux faisceaux 1 produisant chacun une zone 5 d'émission EUV résulte en une émission totale d'EUV référencée 7 qui présente un maximum en direction de l'axe moyen de collecte 6.

La Figure 2, qui correspond à une coupe transversale selon le plan II-II de la Figure 1, montre un ensemble de dix faisceaux lasers qui sont disposés en couronne et de façon symétrique autour de l'axe moyen de collecte 6 (qui est perpendiculaire au plan de la Figure 2). Les faisceaux lasers 1 convergent tous vers la cible 4 en étant légèrement inclinés par rapport au plan de la Figure 2. Les faisceaux laser peuvent être répartis sur plusieurs couronnes concentriques. Ils peuvent aussi être disposés de façon non symétrique par rapport à un plan contenant l'axe moyen de collecte 6. On peut ainsi avoir par exemple deux faisceaux laser d'un côté et quatre faisceaux laser de l'autre côté.

On peut noter que l'émission résultante 7 peut être différente entre le cas où chaque faisceau laser produit un éclairement sur cible 4 qui est suffisant pour produire de l'EUV et le cas où seulement la superposition de plusieurs faisceaux lasers permet d'atteindre l'éclairement optimum pour une émission EUV. Dans les deux cas, le maximum d'émission se fait en direction de l'axe 6 mais dans le deuxième cas l'émission sera plus centrée autour de l'axe moyen de collecte 6.

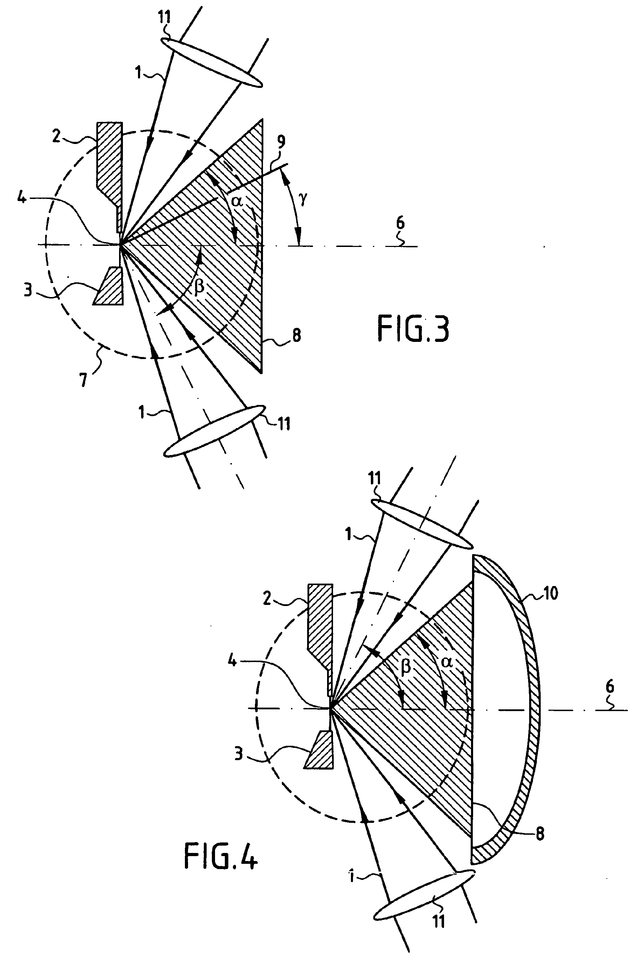

La Figure 3 montre une zone conique 8 qui est effectivement accessible à la collecte du rayonnement EUV 7 avec un dispositif d'émission tel que celui des Figures 1 et 2. La zone conique 8 ayant pour sommet la zone de focalisation des faisceaux lasers 1 sur la cible 4 et pour axe l'axe moyen de collecte 6 du dispositif, présente un demi-angle au sommet a qui constitue un angle potentiel de collecte important (pouvant dépasser 60°) puisque les faisceaux lasers 1 présentent eux-mêmes une inclinaison β comprise entre 60° et 90° par rapport à l'axe moyen de collecte 6. A titre d'exemple, l'inclinaison β peut être égale à 75°.

Les dispositifs collecteurs du rayonnement EUV produit par l'interaction de la cible 4 avec les faisceaux lasers focalisés 1 doivent être conçus pour capter un rayonnement 9 orienté en faisant un angle γ compris entre 0 et α par rapport à l'axe moyen de collecte 6 du dispositif.

La Figure 4 montre un premier exemple de collecteur 10 de rayonnement EUV disposé symétriquement par rapport à l'axe moyen de collecte 6 dans le demi-espace (par rapport à la cible 4) contenant les faisceaux lasers 1 focalisés sur la cible 4 et à l'intérieur de l'espace conique 8. Dans le cas de la Figure 4, le collecteur 10 de rayonnement EUV comprend un dispositif à empilements multicouches diélectriques Mo/Si à incidence normale.

Les empilements multicouches diélectriques ont une réflectivité maximale de 70% en incidence normale et une acceptance angulaire de ± 10°, c'est-à-dire que des rayons avec une incidence de plus de 10° ont une réflectivité inférieure à 20%.

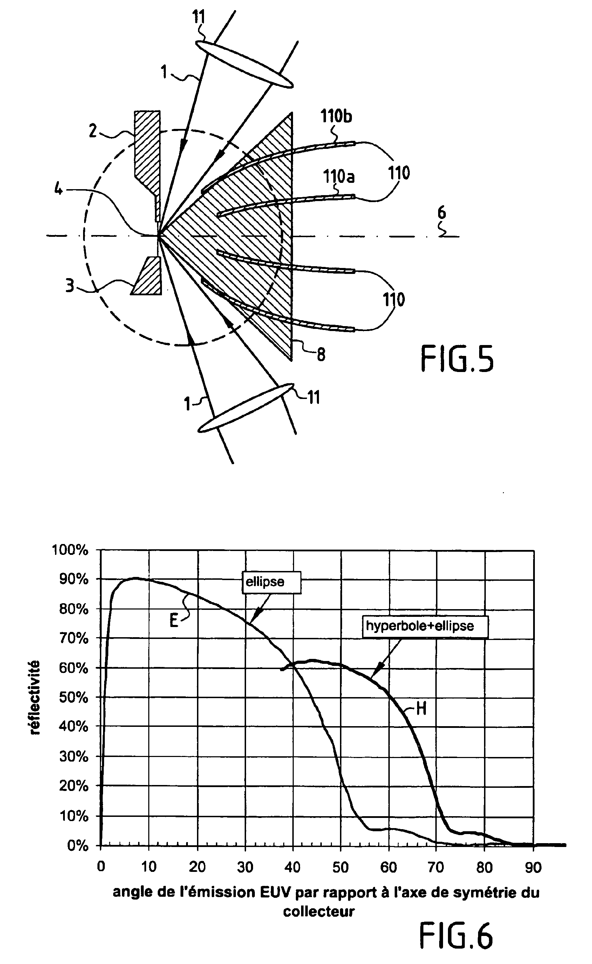

La Figure 5. montre un deuxième exemple de collecteur 110 de rayonnement EUV qui présente un certain nombre d'avantages par rapport au collecteur 10 de la Figure 4.

Le dispositif collecteur 110 est également disposé symétriquement par rapport à l'axe moyen de collecte 6 dans le demi-espace, par rapport à la cible 4, contenant les faisceaux lasers 1 focalisés sur la cible 4 et à l'intérieur de l'espace conique 8.

Dans le cas de la Figure 5, le collecteur 110 de rayonnement EUV est à incidence rasante et permet d'obtenir des réflectivités plus importantes que le collecteur 10 avec des acceptances angulaires similaires.

Avantageusement, dans le cas d'un collecteur 110 à incidence rasante, on peut utiliser des premier et deuxième éléments de collecteur 110a, 110b imbriqués et symétriques par rapport à l'axe moyen de collecte 6.

Selon une première variante de réalisation, les deux éléments de collecteur 110a, 110b présentent chacun une forme d'ellipsoïde de révolution autour de l'axe moyen de collecte 6. Dans ce cas, le collecteur 110 peut collecter avec une bonne efficacité les rayons EUV émis par le plasma et faisant un angle, par rapport à l'axe moyen de collecte 6 du collecteur, inférieur à environ 50°.

Pour calculer l'efficacité de collecte suivant l'ouverture, il suffit de combiner l'équation de la surface du collecteur avec la courbe de variation de réflectivité du matériau utilisé en fonction de l'angle rasant. Sur la Figure 3, on a noté γ l'angle que fait un rayon 9 émis par la source EUV avec l'axe moyen de collecte 6.

La courbe E de la Figure 6 présente la variation de la réflectivité en fonction de l'angle γ que fait l'émission EUV avec l'axe moyen de collecte 6 du collecteur, pour un collecteur de type ellipsoïde de révolution en ruthénium. Cette courbe E montre qu'il est possible de collecter l'émission EUV faisant un angle γ compris entre 0° et 50°. Cependant, seuls 25% des rayons EUV émis avec un angle de 50° sont collectés.

Pour augmenter la collecte des rayons émis à un angle γ supérieur à 40°, il est possible d'associer à un élément interne 110a constitué par un collecteur ellipsoïde de révolution, un élément externe 110b constitué par un objectif de Wolter. Un objectif de Wolter est la combinaison d'un hyperboloïde de révolution (la partie hyperboloïde se trouve à gauche de l'élément 110b sur la Figure 5) avec un ellipsoïde de révolution (à droite de l'élément 110b sur la Figure 5). Les rayons provenant du point source avec un angle γ supérieur à 40° sont réfléchis sur l'hyperboloïde puis sur l'ellipsoïde, c'est-à-dire qu'il y a deux réflexions sur l'élément 110b. Un tel dispositif est connu dans un contexte différent par le brevet US 4 063 088. L'avantage de l'objectif de Wolter est que les deux réflexions se font à des angles rasants faibles où la réflectivité du matériau est plus grande (typiquement 90%).

La courbe H de la Figure 6 présente les réflectivités obtenues par un élément 110a de collecteur ellipsoïdal associé avec un élément 110b de collecteur associant un hyperboloïde et un ellipsoïde. Cette association de collecteur permet d'augmenter significativement le pourcentage de rayons EUV collectés. Ceci montre qu'il est possible de collecter efficacement les rayons émis avec un angle γ au-delà de 60°. Cependant, la collecte devient peu efficace pour des angles supérieurs à 70°.

Il est à noter qu'un collecteur EUV à incidence rasante tel que le collecteur 110, lorsqu'il est utilisé dans le cadre d'une source LPP, présente l'avantage de permettre d'utiliser un pompage différentiel entre la chambre sous vide où est créé le jet formant la cible 4 et la chambre formée par le collecteur 110 lui-même. Le pompage différentiel permet d'avoir dans l'enceinte formée par le collecteur une meilleure qualité de vide, ce qui est très favorable à la transmission du rayonnement EUV qui pourra réellement être utilisé, notamment pour l'application de lithographie.

Dans le cas d'un mode de réalisation de l'invention combinant les caractéristiques illustrées en référence aux Figures 2 et 5, il est possible d'utiliser des dispositifs optiques 11 de focalisation des faisceaux lasers présentant de grandes ouvertures numériques.

Cela est nécessaire, d'une part, pour utiliser des lasers de puissance qui ont généralement un produit diamètre-divergence (M²) plusieurs fois supérieur à celui d'un faisceau laser gaussien et d'autre part, pour focaliser les faisceaux lasers sur de petits diamètres (typiquement entre 10 et 300 micromètres) et pour atteindre des éclairements de l'ordre de 10¹¹ à 10¹⁵ W/cm²), ce qui est indispensable pour obtenir les températures de plasma nécessaires.

Toutefois le dispositif selon l'invention n'est pas limité à l'application dans la lithographie EUV autour de 13,5 nm. Il peut également être appliqué à des dispositifs nécessitant des longueurs d'ondes légèrement différentes, notamment plus courtes, dès lors que la fréquence de travail choisie est suffisamment proche de la plage utilisée en lithographie EUV pour qu'aucun des phénomènes physiques mis en oeuvre ne subisse de discontinuité ou de modification d'échelle notoire.

Ainsi, par exemple, la microscopie et la tomographie dans l'extrême ultraviolet constituent d'autres applications du dispositif de génération de lumière dans l'extrême ultraviolet selon l'invention. Elles utilisent des longueurs d'onde plus courtes, notamment situées entre 2,3 et 4,4 nm, qui correspondent à la fenêtre de transmission de l'eau. La génération de longueurs d'onde plus courtes que pour la lithographie EUV est simplement obtenue en choisissant pour cible un autre matériau émetteur, comme l'azote, l'oxygène ou le carbone, et en augmentant l'éclairement au foyer laser à des valeurs de l'ordre de 10¹³ à 10¹⁵ W/cm². L'expérience montre que dans ce cas, la température Tₑ requise pour le plasma est de l'ordre de 40 à 200 eV.

Le dispositif ainsi obtenu est alors caractérisé en ce que la cible est constituée d'un matériau apte à émettre une longueur d'onde comprise entre 2,3 et 4,4 nm, en ce que l'éclairement au foyer laser a une valeur de l'ordre de 10¹³ à 10¹⁵ W/cm² et en ce qu'il comporte des moyens de fixation et de liaison à un appareil de microscopie ou de tomographie dans l'extrême ultraviolet.

Les systèmes optiques de focalisation de grande ouverture 11 permettent aussi de combiner spatialement plusieurs faisceaux. Dans ce cas plusieurs faisceaux issus des sources lasers passent par le même élément optique pour être focalisés de la même façon au même point.

Comme cela a déjà été indiqué, les moyens optiques de focalisation peuvent être des lentilles, des miroirs ou des systèmes optiques diffractifs tels que des réseaux. L'utilisation de miroirs représente un certain avantage du point de vue de la gestion thermique, car les miroirs peuvent être refroidis efficacement par la surface arrière. Cela n'est pas possible dans le cas de moyens optiques réfractifs (lentilles) ou diffractifs (réseaux) où seul un refroidissement par les bords est possible.

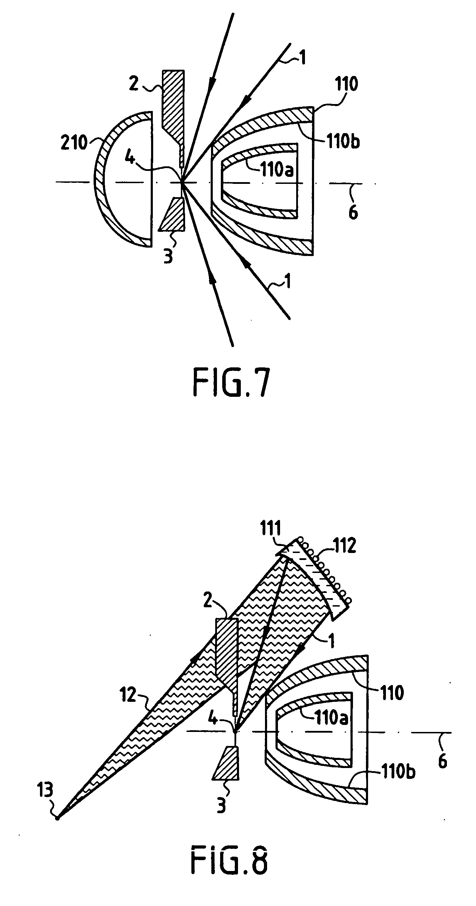

La Figure 7 illustre un mode particulier de réalisation dans lequel il est mis en oeuvre, outre un dispositif collecteur 110 tel que celui décrit en référence à la Figure 5 qui est disposé dans le demi-espace contenant les faisceaux lasers focalisés 1 (à droite de la cible 4 sur la Figure 7), un dispositif collecteur 210 supplémentaire qui est disposé symétriquement par rapport à l'axe de symétrie 6, dans le demi-espace ne contenant pas les faisceaux lasers focalisés 1 (à gauche de la cible 4 sur la Figure 7).

Le collecteur supplémentaire 210 peut par exemple être un miroir à incidence normale avec empilement de multicouches dont la surface est sphérique. Le rayonnement EUV qui se dirige vers ce miroir 210 est ainsi renvoyé dans les éléments 110a, 110b du collecteur 110.

Le collecteur supplémentaire 210 ne travaille qu'avec des rayons en incidence normale (les rayons issus du centre de courbure sont ensuite réfléchis vers le centre de courbure), ce qui lui permet d'avoir toujours une réflectivité de 70%. Il est par ailleurs peu soumis à des endommagements par des débris formés au niveau de la sortie du dispositif éjecteur 2, ces débris étant dirigés principalement dans la direction des faisceaux lasers 1.

Le mode de réalisation illustré sur la Figure 7 avec un premier collecteur 110 à incidence rasante situé, par rapport à la cible 4, du côté des faisceaux lasers focalisés 1, et un deuxième collecteur 210 à incidence normale situé, par rapport à la cible 4, du côté opposé aux faisceaux lasers focalisés 1, constitue ainsi une réalisation optimisée du point de vue de l'efficacité de collecte du rayonnement EUV.

La puissance EUV transmise au second foyer ou foyer intermédiaire (il s'agit de l'image de la source collectée produite par le système de collecte) est calculée, pour les différents types de collecteur, avec un logiciel de tracé de rayons. Ces calculs tiennent compte de la variation de la réflectivité des surfaces en fonction de l'angle d'incidence des rayons. D'excellents résultats sont obtenus avec une couche de ruthénium.

L'attaque latérale de la cible 4 par les faisceaux lasers focalisés permet de ne pas restreindre l'angle de collecte tout en ayant les faisceaux lasers qui focalisent dans le même demi-espace que celui défini par le premier collecteur 10 ou 110. L'angle d'incidence des faisceaux lasers 1 par rapport à l'axe 6 du collecteur 10 ou 110, est donc compris entre environ 60° et 90°.

Un autre avantage de l'attaque latérale est qu'elle utilise des systèmes optiques de focalisation suffisamment éloignés du plasma pour que leurs fonctions ne soient pas perturbées par ce dernier. Il est, en effet, indispensable de limiter, d'une part, l'échauffement des systèmes optiques de focalisation et, d'autre part, leur endommagement. Le plasma est à la fois une source de chaleur importante et une source de particules chargées qui endommagent les surfaces avoisinantes.

La Figure 8 illustre un exemple particulier de réalisation dans lequel les moyens de focalisation comprennent des miroirs 111.

La surface des miroirs 111 peut être, par exemple, de forme ellipsoïdale comme présenté sur la Figure 8. Ces miroirs 111 permettent d'une part de focaliser les faisceaux lasers 1 sur un petit diamètre, typiquement 50 µm, et d'autre part de réduire l'encombrement des faisceaux lasers 12 avant la focalisation. En effet, les faisceaux lasers sont généralement collimatés avant leur focalisation. Cependant, l'utilisation de faisceaux collimatés est incompatible avec la réalisation de la source EUV selon l'invention car les faisceaux peuvent alors être de diamètre important et l'encombrement par les différents éléments de la source ne permet pas le passage de faisceaux collimatés. Les structures permettant la création de la cible 4, celles pour collecter l'énergie EUV et celles pour obtenir le vide dans l'enceinte de la source ne permettent pas un accès aisé des faisceaux lasers 1 sur la cible 4. Au contraire, les miroirs de forme ellipsoïdale 111 permettent le passage aisé des faisceaux lasers 12, avant focalisation, issus des sources lasers 13, entre les éléments du collecteur 110 et les éléments 2, 3 de création de la cible 4.

Les miroirs 111 présentent aussi l'avantage de pouvoir être refroidis par leur face arrière, à l'aide de moyens de refroidissement 112, ce qui permet de les stabiliser en température et de garder leurs propriétés (contrairement aux systèmes optiques réfractifs ou diffractifs).

Les systèmes optiques de focalisation peuvent être disposés en anneau autour du collecteur 110 ("configuration araignée").

La disposition en anneau autour du collecteur 10, 110 présente l'avantage d'amener un grand nombre de faisceaux lasers 1 avec une symétrie de révolution par rapport à l'axe 6 défini par le collecteur EUV 10, 110. Cette symétrie permet d'obtenir une bonne homogénéité spatiale de l'éclairement et donc de l'émission EUV, ce qui est un critère important en particulier pour les sources de photolithographie. Cette symétrie de révolution est exigée au foyer intermédiaire pour être compatible avec les illuminateurs du masque qui sont déjà développés.

La présente invention en assurant de manière optimisée la focalisation d'une pluralité de faisceaux lasers pour la réalisation d'une source EUV de type LPP de forte puissance moyenne, permet d'augmenter fortement la puissance laser incidente et de collecter le rayonnement EUV aussi efficacement qu'avec un seul faisceau laser, l'angle de collecte du rayonnement EUV qui est effectivement disponible n'étant pas diminué par la présence des moyens optiques de focalisation des différents faisceaux lasers.

Le nombre de faisceaux lasers utilisés est supérieur ou égal à 2 et est de préférence compris entre 3 et 20.

Le dispositif selon l'invention est avantageusement appliqué à un appareil de lithographie de substrats semiconducteurs en tant que sources de lumière dans le domaine extrême ultraviolet.

Le dispositif 2 de création sous vide d'une cible 4 telle qu'un jet filamentaire, un jet liquide, un brouillard de gouttelettes ou un jet de gouttelettes individuelles peut être conforme aux exemples de réalisation décrits par exemples dans les documents de brevet WO 02085080 et WO 0130122.

Sur la Figure 8, par souci de simplification, on n'a pas représenté directement la sortie d'une source laser de puissance, mais la référence 13 désigne un foyer intermédiaire du système optique de transport du faisceau jusqu'au miroir de focalisation 111.

Le choix de miroirs 111 en un matériau métallique ou semiconducteur permet d'obtenir un bon compromis entre la conduction thermique et le coefficient de dilatation.

Le dispositif selon l'invention est adapté pour produire un rayonnement dans l'extrême ultraviolet dans la gamme de 1 à 15 nm.

## Revendications

1. Dispositif de génération de lumière dans l'extrême ultraviolet (EUV), comprenant :
a) une pluralité de sources laser de puissance pour émettre une pluralité de faisceaux laser (12),
b) des moyens (11 ; 111) de focalisation des faisceaux laser (12) pour produire des faisceaux laser focalisés (1),
c) des moyens de création d'un espace sous vide avec une pression inférieure à 1 Pa au moins dans la zone où sont focalisés lesdits faisceaux laser focalisés (1),
d) un dispositif (2) de création, dans ledit espace où sont focalisés lesdits faisceaux laser focalisés (1), d'une cible (4) dense apte à émettre par interaction avec lesdits faisceaux laser focalisés (1) un plasma (7) possédant au moins une raie d'émission dans l'extrême ultraviolet,
e) un dispositif récepteur (3) pour recevoir la cible (4) après son interaction avec lesdits faisceaux laser focalisés (1), et
f) au moins un premier dispositif (10 ; 110) collecteur du rayonnement EUV émis par la cible (4),
**caractérisé en ce qu'**il comprend un axe moyen de collecte de rayonnement EUV perpendiculaire à l'axe défini par la cible (4) dense essentiellement linéaire, **en ce que** les moyens (11 ; 111) de focalisation des faisceaux laser sur la cible (4) sont agencés de telle sorte que les faisceaux laser (1) soient focalisés latéralement sur la cible (4) en étant situés dans un même demi-espace par rapport à la cible (4) et en étant inclinés d'un angle (β) prédéterminé compris entre environ 60° et 90° par rapport audit axe moyen de collecte (6) et **en ce que** ledit premier dispositif collecteur (10 ; 110) est disposé symétriquement par rapport audit axe moyen de collecte (6) dans le demi-espace contenant les faisceaux laser (1) focalisés sur la cible (4) et à l'intérieur d'un espace conique centré sur l'axe moyen de collecte (6) avec un sommet situé sur la cible (4) et un demi-angle au sommet (α) inférieur à l'angle (β) d'inclinaison des faisceaux laser focalisés (1) par rapport à l'axe moyen de collecte (6).

2. Dispositif selon la revendication 1, **caractérisé en ce que** le dispositif (2) de création d'une cible (4) dense essentiellement linéaire comprend un dispositif d'injection (2) pour créer sous vide un jet filamentaire, un jet liquide ou un brouillard de gouttelettes ou un jet de gouttelettes individuelles.

3. Dispositif selon la revendication 1 ou la revendication 2, **caractérisé en ce que** les faisceaux laser focalisés (1) inclinés par rapport à l'axe moyen de collecte (6) sont disposés en couronne autour de l'axe moyen de collecte (6).

4. Dispositif selon l'une quelconque des revendications 1 à 3, **caractérisé en ce qu'**il comprend un nombre de faisceaux laser focalisés (1) compris entre 3 et 20.

5. Dispositif selon l'une quelconque des revendications 1 à 4, **caractérisé en ce que** les faisceaux laser focalisés (1) sont disposés de façon non symétrique par rapport à l'axe moyen de collecte (6).

6. Dispositif selon l'une quelconque des revendications 1 à 4, **caractérisé en ce que** les faisceaux laser focalisés (1) sont disposés de façon symétrique par rapport à l'axe moyen de collecte (6).

7. Dispositif selon l'une quelconque des revendications 1 à 6, **caractérisé en ce que** les moyens (11 ; 111) de focalisation sont conçus de manière à produire des faisceaux laser focalisés sur de petits diamètres compris entre environ 10 et 300 µm.

8. Dispositif selon l'une quelconque des revendications 1 à 7, **caractérisé en ce que** les moyens (11 ; 111) de focalisation comprennent des moyens optiques de focalisation (11) pour assurer la focalisation de plusieurs faisceaux laser (12) de puissance dont le produit diamètre-divergence est plusieurs fois supérieur à celui d'un faisceau laser gaussien.

9. Dispositif selon l'une quelconque des revendications 1 à 8, **caractérisé en ce que** les moyens (111) de focalisation comprennent au moins un miroir.

10. Dispositif selon la revendication 9, **caractérisé en ce que** le ou les miroirs sont réalisés en un matériau semiconducteur ou métallique.

11. Dispositif selon la revendication 10, **caractérisé en ce que** le ou les miroirs sont en silicium.

12. Dispositif selon l'une quelconque des revendications 9 à 11, **caractérisé en ce que** des moyens de refroidissement (112) sont disposés sur la face arrière du ou des miroirs constituant les moyens (111) de focalisation.

13. Dispositif selon l'une quelconque des revendications 9 à 12, **caractérisé en ce que** le ou les miroirs constituant les moyens (111) de focalisation présentent une forme ellipsoïdale ou parabolique permettant le passage des faisceaux laser (12) avant focalisation entre le dispositif (2) de création d'une cible et ledit premier dispositif collecteur (10 ; 110).

14. Dispositif selon l'une quelconque des revendications 7 à 13, **caractérisé en ce que** les moyens (11 ; 111) de focalisation sont eux-mêmes placés à l'intérieur de l'espace sous vide.

15. Dispositif selon la revendication 3, **caractérisé en ce que** les moyens de focalisation (11 ; 111) sont disposés en anneau autour dudit premier dispositif collecteur (10 ; 110).

16. Dispositif selon l'une quelconque des revendications 1 à 15, **caractérisé en ce que** ledit premier dispositif collecteur (10) comprend un dispositif à empilement multicouches diélectriques Mo/Si à incidence normale.

17. Dispositif selon l'une quelconque des revendications 1 à 15, **caractérisé en ce que** ledit premier dispositif collecteur (110) comprend un dispositif optique à incidence rasante présentant une surface d'or, ruthénium ou palladium.

18. Dispositif selon la revendication 17, **caractérisé en ce que** ledit premier dispositif collecteur (110) comprend des premier et deuxième éléments de collecteur imbriqués (110a, 110b).

19. Dispositif selon la revendication 18, **caractérisé en ce que** les premier et deuxième éléments de collecteur imbriqués (110a, 110b) présentent chacun une forme d'ellipsoïde de révolution autour de l'axe moyen de collecte (6).

20. Dispositif selon la revendication 18, **caractérisé en ce que** le premier élément de collecteur imbriqué (110a) est un élément interne présentant la forme d'un ellipsoïde de révolution autour de l'axe moyen de collecte (6) tandis que le deuxième élément de collecteur imbriqué (110b) est un élément externe présentant successivement à partir du côté faisant face à la cible (4) la forme d'un hyperboloïde de révolution et la forme d'un ellipsoïde de révolution.

21. Dispositif selon l'une quelconque des revendications 1 à 20, **caractérisé en ce qu'**il comprend en outre un deuxième dispositif collecteur (210) disposé symétriquement par rapport à l'axe moyen de collecte (6) dans le demi-espace délimité par la cible (4) et ne contenant pas les faisceaux laser (11) focalisés sur la cible (4).

22. Dispositif selon la revendication 21, **caractérisé en ce que** le deuxième dispositif collecteur (210) comprend un miroir à incidence normale avec empilement de multicouches dont la surface est sphérique.

23. Dispositif selon l'une quelconque des revendications 1 à 22, **caractérisé en ce qu'**il est adapté pour produire un rayonnement dans l'extrême ultraviolet dans la gamme de 1 à 15 nm.

24. Dispositif selon l'une quelconque des revendications 1 à 23, **caractérisé en ce qu'**il est appliqué à un appareil de lithographie de substrats semiconducteurs en tant que source de lumière dans le domaine extrême ultraviolet autour de 13,5 nm.

25. Dispositif selon l'une quelconque des revendications 1 à 23, **caractérisé en ce que** la cible est constituée d'un matériau apte à émettre une longueur d'onde comprise entre 2,3 et 4,4 nm, **en ce que** l'éclairement au foyer laser a une valeur de l'ordre de 10¹³ à 10¹⁵ W/cm² et **en ce qu'**il comporte des moyens de fixation et de liaison à un appareil de microscopie ou de tomographie dans l'extrême ultraviolet.

## Claims

1. A device for generating light in the extreme ultraviolet (EUV), the device comprising:
a) a plurality of power laser sources for emitting a plurality of laser beams (12);
b) focusing means (11; 111) for focusing the laser beams (12) to produce focused laser beams (1);
c) means for creating an evacuated space with pressure lower than 1 Pa at least in the zone where said focused laser beams (1) are focused;
d) a device (2) for creating a dense target (4) in said space where said focused laser beams (1) are focused, the dense target being suitable for interacting with said focused laser beams (1) to emit a plasma (7) possessing at least one emission line in the extreme ultraviolet;
e) a receiver device (3) for receiving the target (4) after it has interacted with said focused laser beams (1); and
f) at least one first device (10; 110) for collecting the EUV radiation emitted by the target (4);
the device being **characterised in that** it has a mean collection axis for EUV radiation perpendicular to the axis defined by the essentially linear dense target (4); **in that** the focusing means (11; 111) for focusing the laser beams on the target (4) are arranged in such a manner that the laser beams (1) are focused laterally on the target (4) while being situated in a common half-space relative to the target (4) and while being inclined at a predetermined angle (β) lying in the range about 60° to about 90° relative to said mean collection axis (6); and **in that** said first collector device (10; 110) is disposed symmetrically about said mean collection axis (6) in the half-space containing the laser beams (1) focused on the target (4) and within a conical space centred on the mean collection axis (6) with its vertex situated on the target (4) and a half-angle (α) at the vertex less than the angle of inclination (β) of the focused laser beams (1) relative to the mean collection axis (6).

2. A device according to claim 1, **characterised in that** the device (2) for creating an essentially linear dense target (4) comprises an injector device (2) for creating in a vacuum a filamentary jet, a liquid jet, or a mist of droplets, or a jet of individual droplets.

3. A device according to claim 1 or claim 2, **characterised in that** the focused laser beams (1) that are inclined relative to the mean collection axis (6) are disposed in a ring around the mean collection axis (6).

4. A device according to any one of claims 1 to 3, **characterised in that** it comprises a number of focused laser beams (1) lying in the range 3 to 20.

5. A device according to any one of claims 1 to 4, **characterised in that** the focused laser beams (1) are disposed in non-symmetrical manner about the mean collection axis (6).

6. A device according to any one of claims 1 to 4, **characterised in that** the focused laser beams (1) are disposed symmetrically about the mean collection axis (6).

7. A device according to any one of claims 1 to 6, **characterised in that** the focusing means (11; 111) are designed in such a manner as to produce laser beams focused on small diameters lying in the range about 10 µm to about 300 µm.

8. A device according to any one of claims 1 to 7, **characterised in that** the focusing means (11; 111) comprise optical focusing means (11) for focusing a plurality of power laser beams (12) presenting a product of diameter multiplied by divergence that is several times greater than the product of a Gaussian laser beam.

9. A device according to any one of claims 1 to 8, **characterised in that** the focusing means (111) comprise at least one mirror.

10. A device according to claim 9, **characterised in that** the at least one mirror is made of a semiconductor or metal material.

11. A device according to claim 10, **characterised in that** the at least one mirror is made of silicon.

12. A device according to any one of claims 9 to 11, **characterised in that** cooling means (112) are disposed on the rear face of the at least one mirror constituting the focusing means (111).

13. A device according to any one of claims 9 to 12, **characterised in that** the at least one mirror constituting the focusing means (111) are ellipsoidal or parabolic in shape, suitable for passing laser beams (12) prior to focusing between the device (2) for creating a target and said first collector device (10; 110).

14. A device according to any one of claims 7 to 13, **characterised in that** the focusing means (11; 111) are themselves placed inside the evacuated space.

15. A device according to claim 3, **characterised in that** the focusing means (11; 111) are disposed in a ring around said first collector device (10; 110).

16. A device according to any one of claims 1 to 15, **characterised in that** said first collector device (10) comprises a stack of multiple dielectric layers of Mo and Si at normal incidence.

17. A device according to any one of claims 1 to 15, **characterised in that** said first collector device (110) comprises an optical device at grazing incidence presenting a surface of gold, of ruthenium, or of palladium.

18. A device according to claim 17, **characterised in that** said first collector device (110) comprises first and second interleaved collector elements (110a, 110b).

19. A device according to claim 18, **characterised in that** each of the first and second interleave collector elements (110a, 110b) presents a shape that is an ellipsoid of revolution about the mean collection axis (6).

20. A device according to claim 18, **characterised in that** the first interleaved collector element (110a) is an inner element presenting the shape of an ellipsoid of revolution about the mean collection axis (6), while the second interleaved collector element (110b) is an outer element presenting in succession starting from an end facing the target (4); the shape of a hyperboloid of revolution and then the shape of an ellipsoid of revolution.

21. A device according to any one of claims 1 to 20, **characterised in that** it further comprises a second collector device (210) disposed symmetrically about the mean collection axis (6) in the half-space defined by the target (4) and not containing the laser beams (11) focused on the target (4).

22. A device according to claim 21, **characterised in that** the second collector device (210) comprises a normal incident mirror having a multilayer stack of spherical surface.

23. A device according to any one of claims 1 to 22, **characterised in that** it is adapted to produce radiation in the extreme ultraviolet in the range 1 nm to 15 nm.

24. A device according to any one of claims 1 to 23, **characterised in that** it is applied to an apparatus for semiconductor substrate lithography as a light source in the extreme ultraviolet domain around 13.5 nm.

25. A device according to any one of claims 1 to 23, **characterised in that** the target is made of a material suitable for emitting at a wavelength lying in the range 2.3 nm to 4.4 nm, **in that** the illumination at the laser focus has a value of the order of 10¹³ W/cm² to 10¹⁵ W/cm², and **in that** it includes a fastener and connection means for connection to a microscopy or tomography apparatus operating in the extreme ultraviolet.

## Patentansprüche

1. Vorrichtung zum Erzeugen von Licht im extremen Ultravioletten (EUV), umfassend;
a) mehrere Leistungslaserquellen zum Emittieren mehrerer Laserstrahlen (12),
b) Mittel (11; 111) zum Fokussieren der Laserstrahlen (12), um fokussierte Laserstrahlen (1) zu erzeugen,
c) Mittel zum Schaffen eines Unterdruckraums mit einem Druck kleiner als 1 Pa mindestens in der Zone, in der die fokussierten Laserstrahlen (1) fokussiert sind,
d) eine Vorrichtung (2), um in dem Raum, in dem die fokussierten Laserstrahlen (1) fokussiert sind, ein dichtes Ziel (4) zu schaffen, das durch Wechselwirkung mit den fokussierten Laserstrahlen (1) ein Plasma (7) abgeben kann, das mindestens eine Emissionslinie im extremen Ultravioletten besitzt,
e) eine Empfangsvorrichtung (3) zum Empfangen des Ziels (4) nach seiner Wechselwirkung mit den fokussierten Laserstrahlen (1) und
f) mindestens eine erste Sammelvorrichtung (10; 110) der von dem Ziel (4) emittierten EUV-Strahlung,
**dadurch gekennzeichnet, daß** sie eine mittlere EVU-Strahlungssammelachse senkrecht zu der Achse aufweist, die von dem im wesentlichen linearen, dichten Ziel (4) definiert wird, daß die Mittel (11; 111) zum Fokussieren der Laserstrahlen auf das Ziel (4) derart eingerichtet sind, daß die Laserstrahlen (1) seitlich auf das Ziel (4) fokussiert werden, indem sie sich in einem Halbraum in Bezug auf das Ziel (4) befinden und um einen vorbestimmten Winkel (β) zwischen etwa 60° und 90° in Bezug auf die mittlere Sammelachse (6) geneigt sind, und daß die erste Sammelvorrichtung (10; 110) symmetrisch in Bezug auf die mittlere Sammelachse (6) in dem Halbraum angeordnet ist, der die auf das Ziel (4) fokussierten Laserstrahlen (1) enthält und innerhalb eines kegelförmigen Raums, der auf die mittlere Sammelachse (6) zentriert ist, mit einem Scheitel, der sich auf dem Ziel (4) befindet, und einem Halbwinkel auf dem Scheitel (α) kleiner als der Winkel (β) der Neigung der fokussierten Laserstrahlen (1) in Bezug auf die mittlere Sammelachse (6).

2. Vorrichtung nach Anspruch 1, **dadurch gekennzeichnet, daß** die Vorrichtung (2) zum Schaffen eines dichten, im wesentlichen linearen Ziels (4) eine Einspritzvorrichtung (2) aufweist, um unter Unterdruck einen fadenförmigen Strahl, einen flüssigen Strahl oder einen Tröpfchennebel oder einen Strahl einzelner Tröpfchen zu schaffen,

3. Vorrichtung nach Anspruch 1 oder 2, **dadurch gekennzeichnet, daß** die fokussierten Laserstrahlen (1), die in Bezug auf die mittlere Sammelachse (6) geneigt sind, kranzförmig um die mittlere Sammelachse (6) angeordnet sind.

4. Vorrichtung nach einem der Ansprüche 1 bis 3, **dadurch gekennzeichnet, daß** sie eine Anzahl fokussierter Laserstrahlen (1) zwischen 3 und 20 aufweist.

5. Vorrichtung nach einem der Ansprüche 1 bis 4, **dadurch gekennzeichnet, daß** die fokussierten Laserstrahlen (1) asymmetrisch in Bezug auf die mittlere Sammelachse (6) angeordnet sind.

6. Vorrichtung nach einem der Ansprüche 1 bis 4, **dadurch gekennzeichnet, daß** die fokussierten Laserstrahlen (1) symmetrisch zu der mittleren Sammelachse (6) angeordnet sind.

7. Vorrichtung nach einem der Ansprüche 1 bis 6, **dadurch gekennzeichnet, daß** die Mittel (11; 111) zum Fokussieren so konzipiert sind, daß sie Laserstrahlen erzeugen, die auf kleine Durchmesser zwischen etwa 10 und 300 µm fokussiert sind.

8. Vorrichtung nach einem der Ansprüche 1 bis 7, **dadurch gekennzeichnet, daß** die Mittel (11; 111) zum Fokussieren optische Fokussierungsmittel (11) aufweisen, um das Fokussieren mehrerer Laserleistungsstrahlen (12), deren Produkt Durchmesser-Streuung mehrmals so groß ist wie das eines Gaußschen Laserstrahls, sicherzustellen.

9. Vorrichtung nach einem der Ansprüche 1 bis 8, **dadurch gekennzeichnet, daß** die Fokussierungsmittel (111) mindestens einen Spiegel aufweisen.

10. Vorrichtung nach Anspruch 9, **dadurch gekennzeichnet, daß** der oder die Spiegel aus einem Halbleiter- oder metallischen Werkstoff hergestellt ist/sind.

11. Vorrichtung nach Anspruch 10, **dadurch gekennzeichnet, daß** der oder die Spiegel aus Silizium besteht/bestehen.

12. Vorrichtung nach einem der Ansprüche 9 bis 11, **dadurch gekennzeichnet, daß** Kühlmittel (112) auf der Rückseite des oder der Spiegel, der/die die Fokussierungsmittel (111) bildet/bilden, angeordnet sind.

13. Vorrichtung nach einem der Ansprüche 9 bis 12, **dadurch gekennzeichnet, daß** der oder die Spiegel, die die Fokusssierungsmittel (111) bildet/bilden, eine Ellipsoidal- oder Parabelform aufweist/aufweisen, die das Durchgehen der Laserstrahl (12) vor dem Fokussieren zwischen der Vorrichtung (2) zum Schaffen eines Ziels und der ersten Sammelvorrichtung (10; 110) erlaubt.

14. Vorrichtung nach einem der Ansprüche 7 bis 13, **dadurch gekennzeichnet, daß** die Fokussierungsmittel (11; 111) selbst im Inneren des Unterdruckraums plaziert sind,

15. Vorrichtung nach Anspruch 3, **dadurch gekennzeichnet, daß** die Fokussierungsmittel (11; 111) ringförmig um die erste Sammelvorrichtung (10; 110) angeordnet sind.

16. Vorrichtung nach einem der Ansprüche 1 bis 15, **dadurch gekennzeichnet, daß** die erste Sammelvorrichtung (10) eine Vorrichtung mit Stapelung dielektrischer Multischichten Mo/Si mit normalem Einfall aufweist.

17. Vorrichtung nach einem der Ansprüche 1 bis 15, **dadurch gekennzeichnet, daß** die erste Sammelvorrichtung (110) eine optische Vorrichtung mit streifendem Einfall aufweist, die eine Oberfläche aus Gold, Ruthenium oder Palladium aufweist.

18. Vorrichtung nach Anspruch 17, **dadurch gekennzeichnet, daß** die erste Sammelvorrichtung (110) erste und zweite verschachtelte Sammlerelemente (110a, 110b) aufweist.

19. Vorrichtung nach Anspruch 18, **dadurch gekennzeichnet, daß** das erste und das zweite verschachtelte Sammlerelement (110a, 110b) jeweils eine Rotationsellipsoidform um die mittlere Sammelachse (6) aufweisen.

20. Vorrichtung nach Anspruch 18, **dadurch gekennzeichnet, daß** das erste verschachtelte Sammlerelement (110) ein internes Element ist, das die Form eines Rotationsellipsoids um die mittlere Sammelachse (6) aufweist, während das zweite verschachtelte Sammlerelement (110b) ein externes Element ist, das nacheinander ausgehend von der Seite, die dem Ziel (4) gegenüber liegt, die Form eines Rotationshyperboloids und die Form eines Rotationsellipsoids aufweist.

21. Vorrichtung nach einem der Ansprüche 1 bis 20, **dadurch gekennzeichnet, daß** sie ferner eine zweite Sammlervorrichtung (210) aufweist, die zu der mittleren Sammelachse (6) in dem Halbraum, der von dem Ziel (4) abgegrenzt wird und die Laserstrahlen (11), die auf das Ziel (4) fokussiert sind, nicht enthält, symmetrisch angeordnet ist.

22. Vorrichtung nach Anspruch 21, **dadurch gekennzeichnet, daß** die zweite Sammlervorrichtung (210) einen Spiegel mit normalem Einfall mit Multischichtenstapselung aufweist, dessen Oberfläche kugelförmig ist.

23. Vorrichtung nach einem der Ansprüche 1 bis 22, **dadurch gekennzeichnet, daß** sie eine Strahlung im extremen Ultravioletten in dem Bereich von 1 bis 15 nm erzeugen kann.

24. Vorrichtung nach einem der Ansprüche 1 bis 23, **dadurch gekennzeichnet, daß** sie an ein Lithographiegerät für Halbleitersubstrate als Lichtquelle im extremen Ultravioletten um 13,5 nm angewandt wird.

25. Vorrichtung nach einem der Ansprüche 1 bis 23, **dadurch gekennzeichnet, daß** das Ziel aus einem Werkstoff besteht, der eine Wellenlänge zwischen 2,3 und 4,4 nm senden kann, und daß die Beleuchtung im Laserbrennpunkt einen Wert in der Größenordnung von 10¹³ bis 10¹⁵ W/cm² hat, und daß sie Mittel zum Befestigen und Verbinden mit einem Mikroskopie- oder Tomographiegerat im extremen Ultravioletten aufweist.
